# EUROPÄISCHE PATENTSCHRIFT

(11) **EP 2 318 936 B1**
(45) Veröffentlichungstag und Bekanntmachung des Hinweises auf die Patenterteilung: **16.04.2014**
(21) Anmeldenummer: 09779453.1
(22) Anmeldetag: 12.05.2009
(51) Int. Cl.: G06F 13/40, G06F 1/18

(54) **DATENVERARBEITUNGSSYSTEM**
DATA PROCESSING SYSTEM
SYSTÈME DE TRAITEMENT DE DONNÉES

(30) Priorität: 25.07.2008 DE 102008034704
(43) Veröffentlichungstag der Anmeldung: 11.05.2011
(73) Patentinhaber: Fujitsu Technology Solutions Intellectual Property GmbH, 80807 München (DE)
(72) Erfinder: FIETZ, Ralf-Peter, 33104 Paderborn (DE); HESSE, Ronny, 33175 Bad Lippspringe (DE)
(74) Vertreter: Epping - Hermann - Fischer
(86) Internationale Anmeldenummer: PCT/EP2009/055727
(87) Internationale Veröffentlichungsnummer: WO 2010/009912

(56) Entgegenhaltungen:
- US-A- 5 544 006
- US-A1- 2004 221 441
- US-A1- 2005 122 703
- US-A1- 2005 186 824
- US-B1- 7 381 074

## Beschreibung

Die Erfindung betrifft ein Datenverarbeitungssystem mit zumindest einer Hauptplatine, welche in einem Computergehäuse angeordnet ist, und zumindest einer Tochterkarte, welche mittels zumindest einer RISER-Karte mit der Hauptplatine elektrisch verbindbar ist.

Solche Datenverarbeitungssysteme finden zum Beispiel in so genannten BLADE-Servern Verwendung. Die Besonderheit der BLADE-Server liegt darin, dass mehrere Datenverarbeitungssysteme der eingangs genannten Art nebeneinander in einem Baugruppenträger angeordnet sind. Die einzelnen Datenverarbeitungssysteme sind bei BLADE-Servern in einzelne Computergehäuse montiert und werden in den Baugruppenträger eingeschoben. Über eine gemeinsame Rückseitenplatine des Baugruppenträgers, auch BACK-PLANE genannt, sind die einzelnen Datenverarbeitungssysteme gekoppelt und bilden gemeinsam ein Serversystem. An jedem der einzelnen Datenverarbeitungssysteme sind Schnittstellen ausgebildet, welche das einzelne Datenverarbeitungssystem mit der BACK-PLANE elektrisch verbinden. Die einzelnen Datenverarbeitungssysteme sind meist sehr flach ausgebildet und benötigen nur sehr wenig Bauraum. Diese äußere Eigenschaft ist Grund für die Bezeichnung BLADE-Server, da jedes einzelne Datenverarbeitungssystem eines BLADE-Servers durch seine geringe Bauhöhe einem Blatt, einem "Blade" ähnelt. Des Weiteren werden die einzelnen Datenverarbeitungssysteme über eine gemeinsame Energieversorgung und eine gemeinsame Lüftung mit Energie und Kühlluft versorgt. Somit teilen sich alle Datenverarbeitungssysteme in dem Baugruppenträger eine gemeinsame Energie- und Kühlluftversorgung.

Um eine hohe Variabilität der einzelnen Datenverarbeitungssysteme zu erzielen, sollen trotz geringem Raumbedarf zusätzliche Computerkarten, im Folgenden als Tochterkarten bezeichnet, in die einzelnen Computergehäuse einbaubar sein. Um dies zu bewerkstelligen, werden so genannte RISER-Karten verwendet. Mittels der RISER-Karten ist eine parallele Anordnung einer Tochterkarte zur Hauptplatine des Datenverarbeitungssystems möglich.

Eine RISER-Karte ist eine Computererweiterungskarte für ein Datenverarbeitungssystem, die einsetzbar ist, um eine oder mehrere Tochterkarten in ihrer räumlichen Lage im Datenverarbeitungssystem parallel zur Hauptplatine anzuordnen. RISER-Karten sind in verschiedenen Ausführungsformen im Handel erhältlich. Dabei werden passive und aktive RISER-Karten unterschieden, wobei die passiven RISER-Karten lediglich die Kontaktanschlüsse der Steckkontaktleisten der Hauptplatine elektrisch verlängern und so der Tochterkarte zuführen. Aktive RISER-Karten haben zudem eine Steuerelektronik, welche für die Ressourcenverwaltung der mit der RISER-Karte verbundenen Tochterkarte verwendet wird.

Aus den Druck chriften US 5,338,214 A, US 5,544,006 A, US 5,831,821 A und US 5544006 A sind bereits Lösungen bekannt, RISER-Karten sowie eine oder mehrere Tochterkarten in einem Einbaugehäuse aufzunehmen und diese Baugruppe schließlich auf die Hauptplatine eines Computersystems zu setzen. Dabei müssen die RISER-Karten und/oder die Tochterkarten mittels Schraubverbindungen an dem Einbaugehäuse festgelegt werden. Dies stellt einen erhöhten Montageaufwand dar, wobei sich eine Montage gerade in flachen Blade-Server-Systemen als sehr umständlich und schwer handhabbar erweist.

Es ist somit die Aufgabe der Erfindung, den Produktions- und Montageaufwand bei der Herstellung eines Datenverarbeitungssystems zu senken und dennoch ein qualitativ hochwertiges Datenverarbeitungssystem auszubilden.

Diese Aufgabe wird durch die in dem Patentanspruch 1 beschriebenen Maßnahmen gelöst. Vorteilhafte Weiterbildungen sind in den Patentansprüchen 2 bis 12 angegeben.

Zur Lösung der oben genannten Aufgabe ist für ein gattungsgemäßes Datenverarbeitungssystem mit zumindest einer Hauptplatine, welche in einem Computergehäuse angeordnet ist, und zumindest einer Tochterkarte, welche mittels zumindest einer RISER-Karte mit der Hauptplatine elektrisch verbindbar ist, ein Trägerblech vorgesehen. Dieses Trägerblech ist ausgebildet, die RISER-Karte und die Tochterkarte tragend aufzunehmen und kann mit der aufgenommenen RISER-Karte und der aufgenommenen Tochterkarte in dem Computergehäuse angeordnet werden. Das Trägerblech umfasst einen Haltebügel, welcher ausgebildet ist, die aufgenommene RISER-Karte schraubenlos am Trägerblech festzulegen. Ferner umfasst das Trägerblech zumindest einen Haltewinkel sowie zumindest einen Haltebolzen, welche dazu ausgebildet sind, die aufgenommene Tochterkarte schraubenlos am Trägerblech festzulegen.

Ein im Computergehäuse angeordnetes Trägerblech bildet somit eine statische Basis für die damit aufgenommene Tochterkarte sowie für die damit aufgenommene RISER-Karte. Dies bewirkt, dass die Hauptplatine von Befestigungsvorrichtungen für die RISER-Karte oder die Tochterkarte frei bleibt, obgleich die aufgenommene Tochterkarte parallel zur Hauptplatine im Datenverarbeitungssystem angeordnet ist. Damit verbleibt auf der Hautplatine mehr freier Bauraum zur Ausbildung von Leiterbahnen und zur Bestückung mit Bauteilen. Weiter nimmt das Trägerblech auch mechanische Kräfte auf, welche bei der Anordnung des Datenverarbeitungssystems in einem Baugruppenträger auf die Schnittstellen des Datenverarbeitungssystems beim Einstecken der Schnittstellen auf die BACK-PLANE wirken. Diese mechanischen Kräfte entstehen bei der Überwindung von Reibungskräften beim Einführen der Datenverarbeitungssysteme beziehungsweise beim Zusammenführen der elektrischen Kontakte mit den Schnittstellen auf der BACK-PLANE.

Die Kräfte werden von den Schnittstellen direkt auf die Tochterkarten übertragen und werden auf das Trägerblech weitergeleitet und somit in das Computergehäuse abgeleitet. Damit sind hohe mechanische Belastungen von der Tochterkarte abgeleitet und Störungen durch Haarrisse in den Leiterbahnen vermieden. Zudem ist mittels des Trägerblechs eine hohe Maßgenauigkeit bezüglich der Schnittstellenanordnung gegeben, so dass ein Verkanten ebenso wie eine Passungenauigkeit beim Zusammenführen der elektrischen Kontakte vermieden ist.

Zur schraubenlosen Festlegung der aufgenommenen Tochterkarte an dem Trägerblech wirkt der Haltewinkel mit dem Haltebolzen zusammen. Die schraubenlose Festlegung verringert den Montageaufwand der Tochterkarte und erleichtert Wartungsarbeiten am Datenverarbeitungssystem, da mit dem Haltewinkel schnell und einfach die Festlegung der Tochterkarte zu bilden, wie auch zu lösen ist.

Aufgrund der schraubenlosen Montage der RISER-Karte am Trägerblech über den Haltebügel kann die aufgenommene RISER-Karte unabhängig von der Tochterkarte schnell, einfach und dennoch präzise an dem Trägerblech festgelegt werden. Damit ist im Herstellungsprozess des Datenverarbeitungssystems und bei späteren Wartungsarbeiten an dem Datenverarbeitungssystem auch eine unabhängige Montage oder Demontage von Tochterkarten möglich. Dies ermöglicht auch ein problemloses Erweitern des Datenverarbeitungssystems im Rahmen späterer Wartungsarbeiten. Mechanische Kräfte, welche auf die RISER-Karte wirken, werden mittels des Haltebügels auf das Trägerblech abgeleitet. Störungen an der Tochterkarte, welche auf mechanische Belastungen der RISER-Karte zurückzuführen sind, sind somit vermeidbar.

Eine Weiterbildung des Datenverarbeitungssystems sieht vor, dass der Haltebolzen am Trägerblech mit einer Haltebohrung an der aufgenommenen Tochterkarte zusammenwirkt, womit einerseits die Tochterkarte von der Oberfläche des Trägerblechs beabstandet an dem Trägerblech angeordnet werden kann, und zum anderen die mechanischen Kräfte mittels des Haltebolzens auf das Trägerblech übertragen werden. Der Haltebolzen ist bevorzugt ein zylindrischer Körper der vertikal auf dem Trägerblech angeordnet ist und an einem, dem Trägerblech abgewandten Ende eine Verjüngung aufweist, welche vorgesehen ist mit der Haltebohrung der Tochterkarte formschlüssig zusammenzuwirken.

Bevorzugt ist die Tochterkarte an dem Haltebolzen schwimmend gelagert. Das heißt die Tochterkarte ist innerhalb vorbestimmter Freiheitsgrade am Haltebolzen beweglich. So ist in horizontaler Richtung, also parallel zur Ebene der Tochterkarte eine Bewegung der Tochterkarte in vorbestimmten Grenzen möglich. Eine aufgenommene Tochterkarte welche in ihrer flächigen Ausdehnung derart ausgebildet ist, dass sie eine andere aufgenommene Tochterkarte überlappt, lässt sich mittels der schwimmenden Lagerung etwas in horizontaler Richtung verschieben, so dass die überlappte Tochterkarte frei zugänglich ist.

Eine Weiterbildung des Datenverarbeitungssystems umfasst einen Stützbügel, welcher ausgebildet ist, zusammen mit dem Haltebügel die aufgenommene RISER-Karte formschlüssig aufzunehmen. Der Stützbügel ist derart ausgebildet, dass er in Zusammenwirkung mit dem Haltebügel eine von dem Trägerblech beabstandete Anordnung der RISER-Karte auf einfache Weise ermöglicht. Somit ist auch die RISER-Karte unabhängig von der Tochterkarte am Trägerblech beabstandet anordenbar.

Gemäß einer Weiterbildung des Datenverarbeitungssystems ist ein federnd ausgebildetes Rastelement am Haltebügel angeordnet. Damit ist die aufgenommene RISER-Karte im Haltebügelbügel rastend und damit schraubenlos festgelegt. Die schraubenlose Festlegung umfasst den Vorteil einer zeitsparenden Montage der RISER-Karte an dem Trägerblech und verringert somit den Produktionsaufwand für das Datenverarbeitungssystem.

Gemäß einer vorteilhaften Weiterbildung des Datenverarbeitungssystems weist das Trägerblech an zumindest einer Randseite eine Abwinkelung auf. Diese Abwinkelung wirkt mit dem Computergehäuse zusammen, so dass das im Computergehäuse aufgenommene Trägerblech mittels der Abwinkelung im Computergehäuse festgelegt ist. Diese Abwinkelung ergibt darüber hinaus eine Verbesserung der Verwindungssteifigkeit des Trägerblechs, so dass zum einen das Trägerblech mit bereits aufgenommener Tochterkarte und aufgenommener RISER-Karte ausreichend verwindungssteif ist, um mechanische Belastungen durch Verwindungen der Tochterkarte, der RISER-Karte oder der Tochterkarte und der RISER-Karte zueinander zu vermeiden. Weiter umfasst die Abwinkelung den Vorteil, dass mit dieser das Trägerblech im Computergehäuse auf einfache Weise festlegbar ist.

Gemäß einer Weiterbildung des Datenverarbeitungssystems ist das Trägerblech parallel zur Hauptplatine im Computergehäuse angeordnet. Somit ergibt sich eine brückenartige Anordnung des Trägerblechs über die Hauptplatine, und über die gesamte Breite des Computergehäuses hinweg. Das Trägerblech trägt damit auch zur Verwindungssteifigkeit des gesamten Computergehäuses des Datenverarbeitungssystems bei.

Eine vorteilhafte Weiterbildung des Datenverarbeitungssystems umfasst zumindest jeweils ein Zentriermittel sowohl an dem Trägerblech als auch an der Hauptplatine. Diese Zentriermittel wirken formschlüssig zusammen, sobald das Trägerblech im Computergehäuse angeordnet ist. Mittels der Zentriermittel wird erreicht, dass die Tochterkarte zur Hauptplatine exakt positioniert ist, und damit die Schnittstellen der Hauptplatine exakt mit den Schnittstellen der Tochterkarte versatzfrei und maßgerecht in die Schnittstellenkontakte der BACK-PLANE einführbar sind. Die Tochterkarte weist zu diesem Zweck eine Zentrierbohrung auf, welche mit den Zentriermitteln zusammenwirkt. Somit sind mechanische Verspannungen vermieden, welche ein Zueinanderführen der Schnittstellen verhindern. Gemäß einer Weiterbildung des Datenverarbeitungssystems sind die Zentriermittel aus einer Zentrierhülse und einem Zentrierbolzen gebildet.

Eine Weiterbildung des Datenverarbeitungssystems sieht vor, den Haltewinkel federnd auszubilden, wobei der federnd ausgebildete Haltewinkel eine Rastnase umfasst. Mit dieser Rastnase ist die aufgenommene Tochterkarte rastend an dem Trägerblech festgelegt.

Gemäß einer Weiterbildung des Datenverarbeitungssystems ist der Haltebügel, welcher ausgebildet ist, die RISER-Karte aufzunehmen, in Form und Größe den Abmessungen einer Steckkontaktleiste der aufgenommenen RISER-Karte derart angepasst, dass die Steckkontaktleiste der aufgenommenen RISER-Karte von dem Haltebügel an zumindest drei Außenseiten formschlüssig umfasst ist. Somit sind die Steckkontaktleiste der aufgenommenen RISER-Karte und damit die gesamte RISER-Karte mittels des Haltebügels und des federnd ausgebildeten Rastelements einfach und sicher am Trägerblech festgelegt.

Eine Weiterbildung des Datenverarbeitungssystems sieht vor, dass der Stützbügel brückenartig auf dem Trägerblech angeordnet ist und an zumindest einer Seite der Steckkontaktleiste der aufgenommenen RISER-Karte diese stützend aufnimmt. Somit ist die Steckkontaktleiste der aufgenommenen RISER-Karte zwischen dem Stützbügel und dem Haltebügel formschlüssig aufgenommen. Damit ist die beabstandete Festlegung der aufgenommenen RISER-Karte verbessert ausgebildet.

Vorstehend sind die Erfindung und vorteilhafte Weiterbildungen beschrieben. Nachfolgend sind diese anhand eines Ausführungsbeispiels unter Bezugnahme auf 6 Figuren näher erläutert. Es zeigt die
Figur 1 eine perspektivische Darstellung eines Trägerblechs mit einer aufgenommenen Tochterkarte,
Figur 2 eine perspektivische Darstellung des Trägerblechs mit einer aufgenommenen RISER-Karte,
Figur 3 eine perspektivische Darstellung des Trägerblechs mit zwei aufgenommenen Tochterkarten,
Figur 4 eine perspektivische Darstellung des Trägerblechs mit zwei aufgenommenen Tochterkarten und zwei aufgenommenen RISER-Karten,
Figur 5 eine perspektivische Darstellung eines Datenverarbeitungssystems mit einer Hauptplatine,
Figur 6 eine perspektivische Darstellung des Datenverarbeitungssystems mit aufgenommenem Trägerblech.

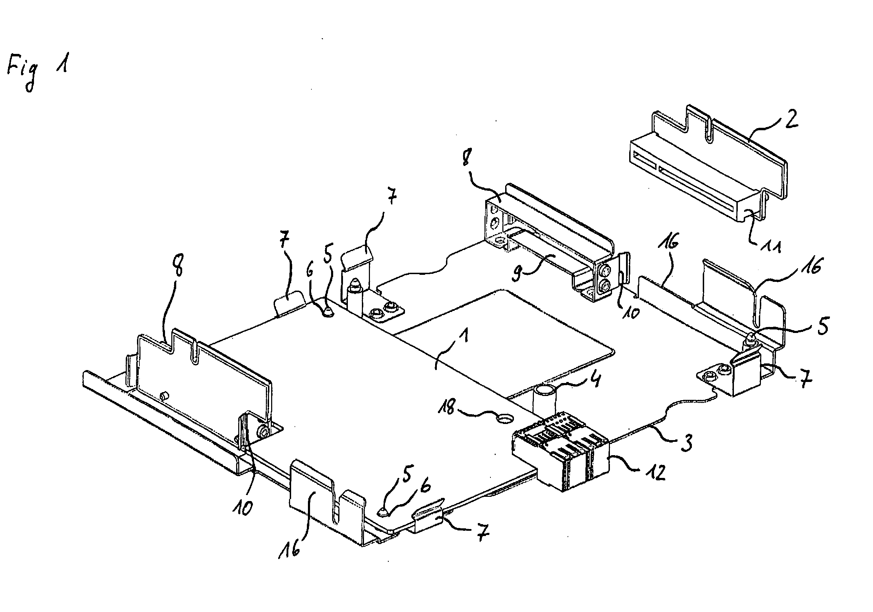

Es zeigt die Figur 1 eine perspektivische Darstellung einer Tochterkarte 1, einer RISER-Karte 2 und eines Trägerblechs 3. Das Trägerblech 3 umfasst eine Zentrierhülse 4, die auf dem Trägerblech 3 angeordnet ist. Auf dem Trägerblech 3 sind weiter Haltebolzen 5 angeordnet, welche zur Aufnahme in Haltebohrungen 6 in jeweils diagonal gegenüber liegenden Außenecken der Tochterkarte 1 angeordnet sind. Für jeden Haltebolzen 5 ist zumindest eine Haltebohrung 6 an der Tochterkarte 1 vorgesehen. Eine am Trägerblech 3 aufgenommene Tochterkarte 1 nimmt demzufolge die Haltebolzen 5 in den Haltebohrungen 6 auf. Dazu sind die Haltebolzen 5 zylindrisch ausgeführt und weisen eine zylindrische Verjüngung an der von der Oberfläche des Trägerblechs 3 abgewandten Seite auf. Die Zentrierhülse 4 ist ein zylindrischer Hohlkörper der vertikal auf der Oberfläche des Trägerblechs 3 angeordnet ist.

Jedem Haltebolzen 5 ist in seiner Nachbarschaft ein Haltewinkel 7 zugeordnet, der als rechtwinklig abgewinkeltes Federblech ausgebildet ist. Zudem umfasst der Haltewinkel 7 eine Rastnase, welche die aufgenommene Tochterkarte 1 mittels der Haltebolzen 5 von der Oberfläche des Trägerblechs 3 beabstandet festlegt. Durch das Zusammenwirken des Haltebolzens 5, der Haltebohrung 6 und der Tochterkarte 1 und dem Haltewinkel 7 wird die Tochterkarte 1 in einem vorbestimmten Abstand zum Trägerblech 3 auf dem Trägerblech 3 festgelegt. Damit ist der Abstand zum Trägerblech 3 exakt gebildet. In horizontaler Richtung bleibt die Tochterkarte innerhalb vorbestimmter Grenzen beweglich.

Die Figur 1 zeigt weiterhin an einem vom Haltebolzen 5 freien Außeneck des Trägerbleches 3 einen Haltebügel 8, der ausgebildet ist, in Zusammenwirkung mit einem Stützbügel 9 die RISER-Karte 2 aufzunehmen. Am Haltebügel 8 ist zudem ein Rastelement 10, insbesondere ein federnd gelagertes Rastelement 10 vorgesehen, welches eine Steckkontaktleiste 11 der RISER-Karte 2 zwischen dem Haltebügel 8 und dem Stützbügel 9 rastend festlegt. Die Steckkontaktleiste 11 der RISER-Karte 2 ist mit der RISER-Karte 2 verbunden, so dass mittels der Steckkontaktleiste 11 der RISER-Karte 2 und deren Festlegung zwischen den Haltebügel 8 und dem Stützbügel 9 und dem federnd gelagerten Rastelement 10 auch die RISER-Karte 2 am Trägerblech 3 festgelegt ist.

Die Figur 1 zeigt ferner das Trägerblech 3 in einer Ausführungsform, in der es ausgebildet ist, zwei Tochterkarten 1 nebeneinander aufzunehmen. Dazu ist an gegenüber liegenden Außenseiten des Trägerblechs 3 jeweils ein Haltebügel 8 mit einem Stützbügel 9 und jeweils zumindest einem federnd gelagerten Rastelement 10 vorgesehen. Ebenso sind an der Aufnahmeposition für die erste oder zweite Tochterkarte 1 jeweils auch zwei Haltebolzen 5 und eine Zentrierhülse 4 vorgesehen.

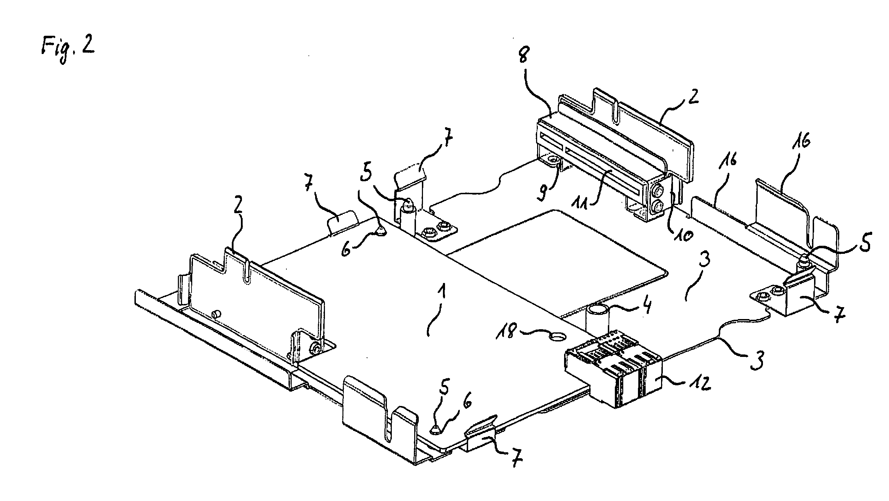

Die Figur 2 zeigt eine perspektivische Darstellung des bereits in Figur 1 beschriebenen Trägerblechs 3, wobei die Steckkontaktleiste 11 der RISER-Karte 2 zwischen dem Haltebügel 8 und dem Stützbügel 9 aufgenommen ist. Das federnd ausgebildete Rastelement 10 hält verrastend die Steckkontaktleiste 11 der RISER-Karte 2 zwischen dem Haltebügel 8 und dem Stützbügel 9.

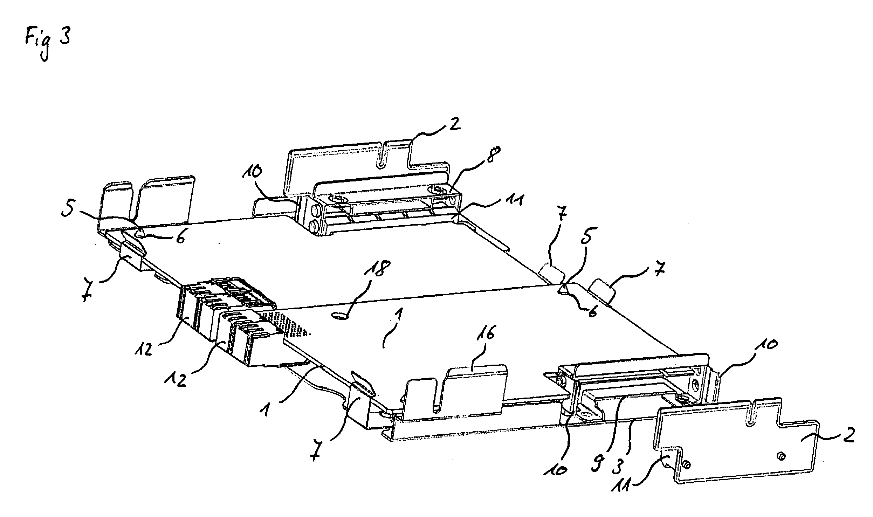

Die Figur 3 zeigt ein Trägerblech 3 mit zwei aufgenommenen Tochterkarten 1. Bei den aufgenommenen Tochterkarten 1 am Trägerblech 3 verrastet jeweils der Haltewinkel 7 an der Außenkante der Tochterkarte 1. Dies legt mittels des Haltebolzens 5 und der Haltebohrung 6 die Tochterkarte 1 auf dem Trägerblech 3 beabstandet fest. In der Figur 3 ist weiter lediglich die Tochterkarte 1 am Trägerblech 3 montiert, die RISER-Karte 2 ist demontiert dargestellt.

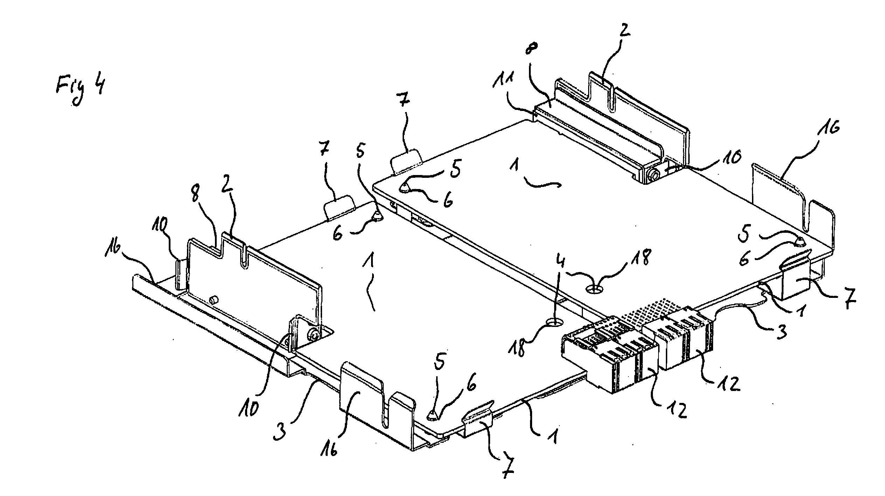

Die Figur 4 zeigt eine perspektivische Darstellung eines vormontierten Trägerblechs 3 mit 2 aufgenommenen Tochterkarten 1, welche jeweils Schnittstellen 12 umfassen. Die Tochterkarten 1 sind gemäß einer Achsenspiegelung zueinander angeordnet, so dass die Ausrichtung der Schnittstellen 12 der jeweiligen Tochterkarten 1 zueinander fluchtend ist. Aufgrund einer außermittigen Anordnung der Schnittstellen 12 auf den Tochterkarten 1 sind die Tochterkarten 1 am Trägerblech 3 in zwei voneinander verschiedenen Ebenen angeordnet, um zu zueinander fluchtenden Schnittstellen 12 zu gelangen. Dem entsprechend sind die Haltebolzen 5 und die Haltewinkel 7 für jede der beiden Tochterkarten 1 in voneinander verschiedenen Längen ausgebildet. Ebenso ist die Zentrierhülse 4 für jede der beiden Tochterkarten 1 den unterschiedlichen Ebenen durch voneinander verschiedene Längen der Zentrierhülsen 4 entsprechend angepasst. An den Außenseiten des Trägerbleches 3 sind Abwinkelungen 16 vorgesehen, die zum einen eine Festlegung des Trägerbleches 3 in einem Computergehäuse ermöglichen, zum anderen auch die Verwindungssteifigkeit des Trägerbleches 3 verbessern.

Zum allgemeinen Verständnis sei die Achsenspiegelung wie folgt definiert. Die Achsenspiegelung ordnet jedem Punkt einen Bildpunkt zu, der dadurch bestimmt ist, dass die Verbindungsstrecke der beiden Punkte von einer Spiegelachse rechtwinklig halbiert wird. Die Fixpunkte einer Achsenspiegelung sind genau die Punkte der Spiegelachse. Diese Achse wird darum auch als Fixpunktgerade bezeichnet. Die Achsenspiegelung ist eine Kongruenzabbildung. Wenn zwei kongruente Objekte vorliegen, können diese in jedem Fall durch Komposition von höchstens drei Achsenspiegelungen ineinander übergeführt werden. Die Achsenspiegelung wird deshalb als ein Grundbegriff der metrischen Geometrie verwendet.

Die Figur 4 zeigt weiter am Trägerblech 3 aufgenommene Tochterkarten 1, die bereits mit am Trägerblech 3 aufgenommenen RISER-Karten 2 elektrisch kontaktiert sind. Die unterschiedlichen Montageebenen der Tochterkarten 1 sind für die Festlegung der RISER-Karte 2 ebenso berücksichtigt und eine unterschiedliche Montageebene für die RISER-Karten 2 mittels des Stützbügels 9 gebildet.

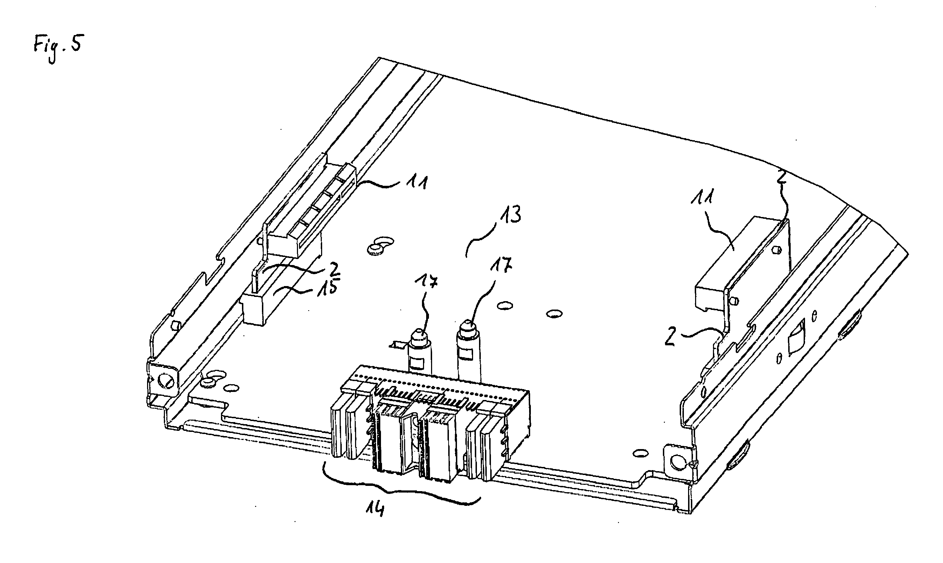

Die Figur 5 zeigt ein Datenverarbeitungssystem in einem Computergehäuse mit einer Hauptplatine 13 und deren Schnittstellen 14 zu einer BACK-PLANE hin. An der Hauptplatine 13 angeordnet sind Zentrierbolzen 17, die gemäß den voneinander verschiedenen Montageebenen der Tochterkarten 1 in voneinander verschiedenen Längen ausgeführt sind. Die Hauptplatine 13 weist an ihren jeweiligen Außenseiten eine Steckkontaktleiste 15 auf, die vorgesehen ist, die RISER-Karte 2 aufzunehmen. Mittels der Zentrierbolzen 17 erfolgt eine exakte Positionierung der Tochterkarten 1 in horizontaler Richtung.

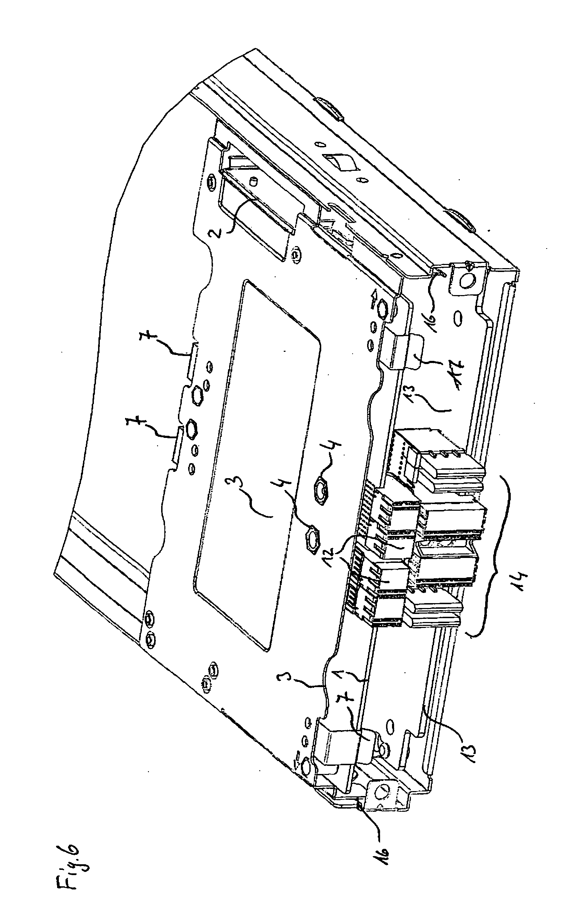

Die Figur 6 zeigt das Datenverarbeitungssystem mit einem montierten Trägerblech 3 und den vorstehend beschriebenen, am Trägerblech 3 aufgenommenen RISER-Karten 2 und Tochterkarten 1. Mittels der Zentrierbolzen 17 und Zentrierhülsen 4 gelingt es zusammen mit einer Zentrierbohrung 18 an einer der Tochterkarten 1 die Schnittstellen 12 und 14 zueinander exakt auszurichten, so dass die Tochterkarten 1 so exakt positioniert sind, dass deren Schnittstellen 12 mit den Schnittstellen 14 der Hauptplatine 13 im Verbund in die Gegenstücke auf der BACK-PLANE gesteckt werden können, ohne dass es durch Versatz zu Verspannungen kommt oder die Steckung dadurch unmöglich wird. Mittels der vorstehend beschriebenen Fixierung der Tochterkarten 1 durch Haltebolzen 5 und Zentrierbolzen 17 in Zusammenspiel mit Zentrierhülsen 4 gelingt es, die Fixierung der Tochterkarten 1 auch stabil genug auszuführen, um Steck- und Ziehkräfte beim Montieren oder Demontieren des Datenverarbeitungssystem in einen Rahmenträger und dessen Stecksystem aufzunehmen.

### Bezugszeichenliste

- 1: Tochterkarte
- 2: RISER-Karte
- 3: Trägerblech
- 4: Zentrierhülse
- 5: Haltebolzen
- 6: Haltebohrung
- 7: Haltewinkel
- 8: Haltebügel
- 9: Stützbügel
- 10: Rastelement
- 11: Steckkontaktleiste der RISER-Karte
- 12: Schnittstellen der Tochterkarte
- 13: Hauptplatine
- 14: Schnittstellen der Hauptplatine
- 15: Steckkontaktleiste der Hauptplatine
- 16: Abwinkelung
- 17: Zentrierbolzen
- 18: Zentrierbohrung

## Patentansprüche

1. Datenverarbeitungssystem mit zumindest
- einer Hauptplatine (13), welche in einem Computergehäuse angeordnet ist,
- einer Tochterkarte (1), welche mittels zumindest
- einer RISER-Karte (2) mit der Hauptplatine (13) elektrisch verbindbar ist,
wobei ein Trägerblech (3) vorgesehen ist, welches ausgebildet ist, die RISER-Karte (2) und die Tochterkarte (1) tragend aufzunehmen, und mit der aufgenommenen RISER-Karte (2) und der aufgenommenen Tochterkarte (1) in dem Computergehäuse angeordnet werden kann, **gekennzeichnet dadurch dass** das Trägerblech (3) einen Haltebügel (8) umfasst, welcher ausgebildet ist, die aufgenommene RISER-Karte (2) schraubenlos am Trägerblech (3) festzulegen, und dass das Trägerblech (3) zumindest einen Haltewinkel (7) sowie zumindest einen Haltebolzen (5) umfasst, welche dazu ausgebildet sind, die aufgenommene Tochterkarte (1) schraubenlos am Trägerblech (3) festzulegen.

2. Datenverarbeitungssystem nach Anspruch 1,
**dadurch gekennzeichnet, dass**
der Haltebolzen (5) mit zumindest einer Haltebohrung (6) an der aufgenommenen Tochterkarte (1) zusammenwirkt.

3. Datenverarbeitungssystem nach Anspruch 1 oder 2, **dadurch gekennzeichnet, dass**
ein Stützbügel (9) vorgesehen ist, welcher ausgebildet ist, zusammen mit dem Haltebügel (8) die aufgenommene RISER-Karte (2) formschlüssig aufzunehmen.

4. Datenverarbeitungssystem nach einem der Ansprüche 1 bis 3, **dadurch gekennzeichnet, dass**
der Haltebügel (8) ein federnd ausgebildetes Rastelement (10) umfasst, welches die aufgenommene RISER-Karte (2) im Haltebügel (8) festlegt.

5. Datenverarbeitungssystem nach einem der Ansprüche 1 bis 4, **dadurch gekennzeichnet, dass**
das Trägerblech (3) an zumindest einer Randseite eine erste Abwinkelung (16) aufweist, welche mit dem Computergehäuse derart zusammenwirkt, dass das im Computergehäuse aufgenommene Trägerblech (3) mittels der Abwinkelung (16) im Computergehäuse festgelegt ist.

6. Datenverarbeitungssystem nach einem der Ansprüche 1 bis 5, **dadurch gekennzeichnet, dass**
das Trägerblech (3) parallel zur Hauptplatine (13) im Computergehäuse angeordnet ist.

7. Datenverarbeitungssystem nach einem der Ansprüche 1 bis 6, **dadurch gekennzeichnet, dass**
zumindest jeweils ein Zentriermittel an dem Trägerblech (3) und an der Hauptplatine (13) angeordnet ist, wobei die Zentriermittel formschlüssig zusammenwirken, wenn das Trägerblech (3) im Computergehäuse angeordnet ist.

8. Datenverarbeitungssystem nach Anspruch 7,
**dadurch gekennzeichnet, dass**
die Tochterkarte (1) eine Zentrierbohrung (18) umfasst, welche mit den Zentriermitteln zusammenwirkt, wenn die Tochterkarte (1) mit dem Trägerblech (3) im Computergehäuse angeordnet ist.

9. Datenverarbeitungssystem nach Anspruch 7 oder 8,
**dadurch gekennzeichnet, dass**
die Zentriermittel aus einer Zentrierhülse (4) und einem Zentrierbolzen (17) gebildet sind.

10. Datenverarbeitungssystem nach einem der Ansprüche 1 bis 9, **dadurch gekennzeichnet, dass**
der Haltewinkel (7) federnd ausgebildet ist und eine Rastnase umfasst, mit welcher die aufgenommene Tochterkarte (1) rastend festgelegt ist.

11. Datenverarbeitungssystem nach einem der Ansprüche 1 bis 10, **dadurch gekennzeichnet, dass**
der Haltebügel (8) in Form und Größe den Abmessungen einer Steckkontaktleiste (11) der aufgenommenen RISER-Karte (2) derart angepasst ist, dass die Steckkontaktleiste (11) der aufgenommenen RISER-Karte (2) von dem Haltebügel (8) an zumindest drei Außenseiten formschlüssig umfasst ist.

12. Datenverarbeitungssystem nach einem der Ansprüche 3 bis 11, **dadurch gekennzeichnet, dass**
der Stützbügel (9) brückenartig auf dem Trägerblech (3) angeordnet ist und an zumindest einer Seite der Steckkontaktleiste (11) der aufgenommenen RISER-Karte (2) diese stützend aufnimmt, so dass die Steckkontaktleiste (11) der aufgenommenen RISER-Karte (2) zwischen dem Stützbügel (9) und dem Haltebügel (8) formschlüssig aufgenommen ist.

## Claims

1. Data-processing system having at least
- one main board (13) which is arranged in a computer housing,
- a daughter card (1), which can be electrically connected by means of at least
- one riser card (2) to the main board (13),
wherein a carrier sheet (3) is provided, which carrier sheet (3) is designed to hold the riser card (2) and the daughter card (1) in a carrying manner and can be arranged with the held riser card (2) and the held daughter card (1) in the computer housing, **characterized in that** the carrier plate (3) comprises a retaining clip (8) which is designed to secure the held riser card (2) to the carrier plate (3) without screws, and **in that** the carrier plate (3) comprises at least one retaining bracket (7) and also at least one retaining pin (5), which retaining bracket (7) and retaining pin (5) are designed to secure the held daughter card (1) to the carrier plate (3) without screws.

2. Data-processing system according to Claim 1, **characterized in that** the retaining pin (5) interacts with at least one retaining bore (6) in the held daughter card (1).

3. Data-processing system according to Claim 1 or 2, **characterized in that** a supporting clip (9) is provided, which supporting clip (9) is designed, together with the retaining clip (8), to hold the held riser card (2) in an from-locking manner.

4. Data-processing system according to one of Claims 1 to 3, **characterized in that** the retaining clip (8) comprises a spring-action latching element (10), which secures the held riser card (2) in the retaining clip (8).

5. Data-processing system according to one of Claims 1 to 4, **characterized in that** the carrier sheet (3) has a first angled portion (16) on at least one edge side, the said first angled portion (16) interacting with the computer housing in such a way that the carrier plate (3) which is held in the computer housing, is secured in the computer housing by means of the angled portion (16).

6. Data-processing system according to one of Claims 1 to 5, **characterized in that** the carrier sheet (3) is arranged in the computer housing parallel to the main board (13).

7. Data-processing system according to one of Claims 1 to 6, **characterized in that** at least in each case one centring means is arranged on the carrier sheet (3) and on the main board (13), wherein the centring means interact in an interlocking manner when the carrier plate (3) is arranged in the computer housing.

8. Data-processing system according to Claim 7, **characterized in that** the daughter card (1) comprises a centring bore (18) which interacts with the centring means when the daughter card (1) is arranged in the computer housing with the carrier sheet (3).

9. Data-processing system according to Claim 7 or 8, **characterized in that** the centring means are formed from a centring sleeve (4) and a centring pin (17).

10. Data-processing system according to one of Claims 1 to 9, **characterized in that** the retaining bracket (7) is of spring-action design and comprises a latching lug with which the held daughter card (1) is secured in a latching manner.

11. Data-processing system according to one of Claims 1 to 10, **characterized in that** the retaining clip (8) is matched in respect of shape and size to the dimensions of a plug contact strip (11) of the held riser card (2) in such a way that the plug contact strip (11) of the held riser card (2) is enclosed in an interlocking manner on at least three outer sides by the retaining clip (8).

12. Data-processing system according to one of Claims 3 to 11, **characterized in that** the supporting clip (9) is arranged on the carrier sheet (3) in a bridge-like manner and, on at least one side of the plug contact strip (11) of the held riser card (2), holds the said plug contact strip in a supporting manner, so that the plug contact strip (11) of the held riser card (2) is held between the supporting clip (9) and the retaining clip (8) in an interlocking manner.

## Revendications

1. Système de traitement de données comportant au moins :
- une carte mère (13) qui est disposée dans un boîtier d'ordinateur,
- une carte fille (1) qui peut être électriquement connectée au moyen d'au moins
- une carte RISER (2) à la carte mère (13),
dans lequel il est prévu une tôle de support (3) qui est conçue pour recevoir de manière à les supporter la carte RISER (2) et la carte fille (1) et qui peut être disposée avec la carte RISER (2) reçue et la carte fille (1) reçue dans le boîtier d'ordinateur, **caractérisé en ce que** la tôle de support (3) comprend un étrier de retenue (8) qui est conçu pour fixer sans vis la carte RISER (2) reçue à la tôle de support (3), et **en ce que** la tôle de support (3) comprend au moins une patte de retenue (7) ainsi qu'au moins un boulon de retenue (5) qui sont conçus de manière à fixer sans vis la carte fille (1) reçue à la tôle de support (3).

2. Système de traitement de données selon la revendication 1, **caractérisé en ce que** le boulon de retenue (5) coopère avec au moins un alésage de retenue (6) ménagé sur la carte fille (1) reçue.

3. Système de traitement de données selon la revendication 1 ou 2, **caractérisé en ce qu'**il est prévu un étrier d'appui (9) qui est conçu pour recevoir par complémentarité de forme avec l'étrier de retenue (8) la carte RISER (2) reçue.

4. Système de traitement de données selon l'une quelconque des revendications 1 à 3, **caractérisé en ce que** l'étrier de retenue (8) comprend un élément de verrouillage (10) réalisé de manière élastique, qui fixe la carte RISER (2) reçue dans l'étrier de retenue (8).

5. Système de traitement de données selon l'une quelconque des revendications 1 à 4, **caractérisé en ce que** la tôle de support (3) comporte sur au moins une périphérie une première patte coudée (16) qui coopère avec le boîtier d'ordinateur de telle manière que la tôle de support (3) reçue dans le boîtier d'ordinateur soit fixée dans le boîtier d'ordinateur au moyen de la patte coudée (16).

6. Système de traitement de données selon l'une quelconque des revendications 1 à 5, **caractérisé en ce que** la tôle de support (3) est disposée parallèlement à la carte mère (13) dans le boîtier d'ordinateur.

7. Système de traitement de données selon l'une quelconque des revendications 1 à 6, **caractérisé en ce qu'**au moins un moyen de centrage respectif est agencé sur la tôle de support (3) et sur la carte mère (13), dans lequel les moyens de centrage coopèrent l'un avec l'autre par complémentarité de forme lorsque la tôle de support (3) est disposée dans le boîtier d'ordinateur.

8. Système de traitement de données selon la revendication 7, **caractérisé en ce que** la carte fille (1) comprend un alésage de centrage (18) qui coopère avec les moyens de centrage lorsque la carte fille (1) est disposée dans le boîtier d'ordinateur avec la tôle de support (3).

9. Système de traitement de données selon la revendication 7 ou 8, **caractérisé en ce que** les moyens de centrage sont constitués d'un manchon de centrage (4) et d'un boulon de centrage (17).

10. Système de traitement de données selon l'une quelconque des revendications 1 à 9, **caractérisé en ce que** la patte de retenue (7) est réalisée de manière élastique et comprend un cliquet au moyen duquel la carte fille (1) reçue est fixée par encliquetage.

11. Système de traitement de données selon l'une quelconque des revendications 1 à 10, **caractérisé en ce que** l'étrier de retenue (8) est adapté en forme et en taille aux dimensions d'un connecteur multipoints (11) de la carte RISER (2) reçue de telle manière que le connecteur multipoints (11) de la carte RISER (2) reçue soit enveloppé par complémentarité de forme par l'étrier de retenue (8) sur au moins trois faces extérieures.

12. Système de traitement de données selon l'une quelconque des revendications 3 à 11, **caractérisé en ce que** l'étrier d'appui (9) est disposé sur la tôle de support (3) à la manière d'un pont et, sur au moins une face du connecteur multipoints (11) de la carte RISER (2) reçue, reçoit celui-ci en le soutenant de manière à ce que le connecteur multipoints (11) de la carte RISER (2) reçue soit reçu par complémentarité de forme entre l'étrier d'appui (9) et l'étrier de retenue (8).
